**Europäisches Patentamt**

**European Patent Office**

**Office européen des brevets**

(19)

(11) Veröffentlichungsnummer : **0 125 481**
**B1**

(12) **EUROPÄISCHE PATENTSCHRIFT**

(45) Veröffentlichungstag der Patentschrift :
09.09.87

(21) Anmeldenummer : 84103911.8

(22) Anmeldetag : 07.04.84

(51) Int. Cl.⁴ : **G 03 G  5/05**, G 03 G  5/04,
G 03 G  5/06, G 03 G  5/09,
G 03 G  13/26, H 05 K  3/02,
C 07 D271/10

(54) **Elektrophotographisches Aufzeichnungsmaterial.**

(30) Priorität : 15.04.83 DE 3313798

(43) Veröffentlichungstag der Anmeldung :
21.11.84 Patentblatt 84/47

(45) Bekanntmachung des Hinweises auf die Patenterteilung : 09.09.87 Patentblatt 87/37

(84) Benannte Vertragsstaaten :
BE CH DE FR GB LI NL SE

(56) Entgegenhaltungen :
DE-B- 1 217 785
DE-C- 1 058 836

(73) Patentinhaber : HOECHST AKTIENGESELLSCHAFT
Postfach 80 03 20
D-6230 Frankfurt am Main 80 (DE)

(72) Erfinder : Lind, Erwin, Dr. Dipl.-Chem.
Holunderweg 7
D-6200 Wiesbaden (DE)

**Beschreibung**

Die Erfindung betrifft ein elektrophotographisches Aufzeichnungsmaterial, bestehend aus einem elektrisch leitenden, insbesondere zur Herstellung von Druckformen oder gedruckten Schaltungen geeignetem Schichtträger und einer photoleitfähigen Schicht aus organischem Photoleiter, Bindemittel und Sensibilisator.

Aufzeichnungsmaterialien für die elektrophotographische Reproduktion sind bekannt. Man verwendet sie zum Beispiel in elektrophotographischen Verfahren, bei denen eine photoleitfähige Schicht, die aus organischen oder anorganischen Photoleitern besteht oder diese enthält, unter Abwesenheit von aktinischem Licht elektrostatisch aufgeladen und anschließend bildmäßig belichtet wird. Dabei fließt die elektrische Ladung an den vom Licht getroffenen Stellen ab, und das so erzeugte Bild wird durch einen Entwickler sichtbar gemacht, gegebenenfalls übertragen und fixiert.

Verfahren zur Herstellung elektrophotographischer Aufzeichnungsmaterialien und zur filmlosen Herstellung von Druckformen haben in der Praxis Eingang gefunden. Neben einer guten Lichtempfindlichkeit der photoleitfähigen Schicht ist jedoch auch eine geringe Dunkelentladung und eine geringe Vorbelichtungsempfindlichkeit ausschlaggebend, die die bekannten Schichten nicht immer in ausreichendem Maße besitzen.

Es ist eine große Zahl organischer Verbindungen mit mehr oder weniger guten Photoleitereigenschaften bekannt, mit denen Schichten für die Elektrophotographie hergestellt werden können. Zu den Verbindungen mit weniger guten Photoleitereigenschaften gehören beispielsweise die in der DE-PS 1 217 785 (entsprechend US-PS 3 290 146) beschriebenen Kondensationsprodukte aus einem aromatischen o-Dicarbonsäureanhydrid und einem aromatischen Amin. Zu den Verbindungen, die gute Photoleitereigenschaften aufweisen, gehören beispielsweise die in der DS-PS 1 058 836 (entsprechend US-PS 3 189 447) beschriebenen Oxdiazolderivate.

Ferner ist es bekannt, Gemische verschiedener Photoleiter in elektrophotographischen Aufzeichnungsmaterialien einzusetzen. So wird beispielsweise in der DE-PS 1 217 785 beschrieben, einer photoleitfähigen Schicht aus einem Kondensationsprodukt aus Phthalsäureanhydrid und Diethylanilin ein substituiertes Oxdiazol zuzusetzen. Dadurch wird die Lichtempfindlichkeit der Schicht verbessert.

Insbesondere bei der Herstellung von Druckformen oder gedruckten Schaltungen auf elektrophotographischem Wege spielen aber außer einer guten Lichtempfindlichkeit der photoleitfähigen Schicht eine gute Auflösung und eine tonwertrichtige Wiedergabe gerasterter Bilder eine ausschlaggebende Rolle. Bei der Herstellung von Druckformen werden Reprokameras eingesetzt, die es aufgrund eines speziellen Objektives ermöglichen, auch große Formate, z. B. 680 × 500 mm, so zu belichten, daß auch in den Randzonen noch Feinheiten, z. B. feine Linien oder Rasterpunkte, originalgetreu wiedergegeben werden. Zur scharfen Bildwiedergabe müssen die durch das Objektiv fallenden Lichtstrahlen durch eine Blende begrenzt werden, was längere Belichtungszeiten zur Folge hat. Die Belichtungszeiten liegen heute in der Praxis bei etwa 30 bis 50 sec. Dies bedeutet aber andererseits, daß während dieser Zeit an den nichtbelichteten Stellen die Ladung nicht abfließen darf, d. h. eine zur Herstellung von Druckformen hoher Qualität geeignete Photoleiterschicht darf nicht dunkelleitfähig sein.

Darüberhinaus muß bei der Herstellung von Druckformen auf elektrophotographischem Wege die Photoleiterschicht möglichst in wäßrig-alkalischen Lösungsmitteln löslich sein, was die Verwendung geeigneter Bindemittel bedingt.

Es hat sich jedoch gezeigt, daß bei Verwendung der gut lichtempfindlichen Oxdiazole in Kombination mit alkalilöslichen Bindemitteln die Dunkelentladung so hoch ist, daß nach einer Belichtung in der Reprokamera feine Linien und Rasterpunkte nicht mehr entwickelt werden können.

Es war deshalb Aufgabe der Erfindung, ein elektrophotographisches Aufzeichnungsmaterial zu schaffen, mit einer photoleitfähigen Schicht, die eine geringe Dunkelleitfähigkeit besitzt und nur in geringem Maße vorbelichtungsempfindlich ist. Außerdem sollte das Material einfach herstellbar sein, unter Verwendung von Substanzen, die zum Beispiel preiswert im Handel erhältlich oder doch unkompliziert darstellbar sind.

Die Lösung dieser Aufgabe geht aus von einem elektrophotographischen Aufzeichnungsmaterial, bestehend aus einem elektrisch leitenden, insbesondere zur Herstellung von Druckformen oder gedruckten Schaltungen geeigneten Schichtträger und einer photoleitfähigen Schicht aus organischem Photoleiter, Bindemittel und Sensibilisator, das dadurch gekennzeichnet ist, daß die photoleitfähige Schicht zusätzlich ein Kondensationsprodukt aus Benzophenon-2-carbonsäure und einem Dialkylanilin enthält. Vorzugsweise enthält die photoleitfähige Schicht ein Kondensationsprodukt aus Benzophenon-2-carbonsäure und Diethylanilin.

Hierdurch wird erreicht, daß ein elektrophotographisches Aufzeichnungsmaterial zur Verfügung gestellt werden kann, das eine gute Lichtempfindlichkeit besitzt, d. h. die Hellentladung der Photoleiterschicht ist entsprechend einer Schicht, die kein Kondensationsprodukt enthält, aber die Dunkelleitfähigkeit und die Vorbelichtungsunempfindlichkeit sind erheblich verbessert. Es wurde gefunden, daß das erfindungsgemäße Kondensationsprodukt nur eine geringe Photoleitfähigkeit zeigt, aber überraschend die Eigenschaft besitzt, die in der photoleitfähigen Schicht vorhandenen Ladungsträger, soweit sie nicht rekombinieren, zu binden.

Die Kondensationsprodukte sind leicht herstellbar. Ihre Kondensation wird im sauren Medium, vorzugsweise in Essigsäureanhydrid, durchgeführt und verläuft glatt und mit guter Ausbeute. Außer Benzophenon-2-carbonsäure kommen besonders deren alkylsubstituierte Derivate, vorzugsweise 4'-Methyl-benzophenon-2-carbonsäure, in Frage.

Als Dialkylanilin sind erfindungsgemäß solche besonders geeignet, die 1 bis 4 Kohlenstoffatome in der Alkylgruppe tragen. Vorzugsweise werden Dimethyl- und Diethylanilin eingesetzt.

Als organische Photoleiter sind solche geeignet, wie sie, wie schon angegeben, aus DE-PS 1 058 836 hervorgehen und die Oxdiazolderivate darstellen. Weiterhin sind Oxazolderivate gemäß DE-PS 1 120 875 (entsprechend US-PS 3 257 203) einsetzbar, auch Triphenylamin-, Triphenylmethanderivate, höher kondensierte aromatische Verbindungen, wie Anthracen, benzokondensierte Heterocyclen, Pyrazolin-, Hydrazon-, Imidazol- oder Triazolderivate sind zusätzlich verwendbar. Vorzugsweise werden jedoch Oxdiazole, insbesondere 2,5-Bis(4'-diethylaminophenyl)-1,3,4-oxdiazol, eingesetzt.

Das Mischungsverhältnis zwischen organischem Photoleiter und dem erfindungsgemäßen Kondensationsprodukt kann schwanken. Vorzugsweise werden Mischungsverhältnisse im Bereich von 1 : 1 bis 5 : 1 Gewichtsteilen benutzt.

Überraschenderweise kann man einen Teil des relativ teuren Photoleiters, zum Beispiel des Oxdiazols, durch die relativ billigen, erfindungsgemäßen Kondensationsprodukte ersetzen, ohne daß darunter die Lichtempfindlichkeit der photoleitfähigen Schicht leidet. Der Grad der Substitution hängt auch von den verwendeten Sensibilisatoren ab und kann bis zu 50 % betragen. Durch eine Herabsetzung der Dunkelentladung der photoleitfähigen Schicht steigt der Ladungskontrast zwischen den Bildstellen und den durch Belichten entladenen Nichtbildstellen, was bei dem anschließenden Betonern zu kontrastreichen, randscharfen Tonerbildern führt. Dies ist insbesondere im Falle der Herstellung von Druckformen oder gedruckten Schaltungen sehr von Vorteil, da dort nicht nur ein optisch einwandfreies Bild vorliegen muß, sondern auch Resistenz gegen Entwickler und Ätzen gefordert wird.

Als Bindemittel für die photoleitfähige Schicht seien genannt : Balsamharze, Kolophonium, Schellack und künstliche Harze, wie mit Kolophonium modifizierte Phenolharze und andere Harze mit größerem Kolophoniumanteil, Cumaronharze, Indenharze und die unter den Sammelbegriff « Lack-Kunstharze » fallenden Substanzen. Zu diesen « Lack-Kunstharzen » gehören, wie aus dem Kunststofftaschenbuch von Saechtling-Zebrowski, 11. Auflage (1955), S. 212 ff., hervorgeht, abgewandelte Naturstoffe, wie Celluloseether, Polymerisate, wie Vinylpolymerisate, beispielsweise Polyvinylchlorid, Polyvinylidenchlorid, Polyvinylacetat, Polyvinylacetale, Polyvinylether, Mischpolymerisate aus Vinylchlorid, Vinylacetat und Maleinsäure, Polyacryl-, Polymethacrylester, ferner Polystyrol und Mischpolymerisate, beispielsweise aus Styrol und Maleinsäureanhydrid, Isobutylen, chlorierter Kautschuk, Polykondensate, z. B. Polyester, wie Phthalatharze, Alkydharze, Maleinatharze, Maleinsäure-Kolophonium-Mischester höherer Alkohole, Phenol-Formaldehyd-Harze, kolophoniummodifizierte Phenol-Formaldehyd-Kondensate, Harnstoff-Formaldehydharz, Melamin-Formaldehyd-Kondensate, Aldehydharze, Ketonharze, Xylol-Formaldehydharze, Polyamide, Polyurethane. Auch Phthalsäureester, wie Terephthalsäure bzw. Isophthalsäureethylenglykolpolyester und Polyolefine, wie niedermolekulares Polyethylen, Polypropylen, können für diesen Zweck Verwendung finden.

Vorzugsweise werden die Harze hinsichtlich ihrer Filmeigenschaften und der Haftfestigkeit als Bindemittel eingesetzt. Bei ihrer Auswahl spielen außer den filmbildenden und elektrischen Eigenschaften sowie denen der Haftfestigkeit auf dem Schichtträger vor allem Löslichkeitseigenschaften eine besondere Rolle. Für praktische Zwecke sind zur Herstellung von Druckformen und gedruckten Schaltungen solche Bindemittel besonders geeignet, die in wäßrigen oder alkoholischen Lösungsmittelsystemen, gegebenenfalls unter Säure- oder Alkalizusatz, löslich sind. Aus physiologischen und Sicherheitsgründen scheiden aromatische oder aliphatische, leicht brennbare Lösungsmittel aus. Geeignete Bindemittel sind hiernach hochmolekulare Substanzen, die alkalilöslich machende Gruppen tragen. Solche Gruppen sind beispielsweise Säure-, Anhydrid-, Carboxyl-, Phenol-, Sulfosäure-, Sulfonamid- oder Sulfonimidgruppen. Bevorzugt werden Bindemittel mit hohen Säurezahlen eingesetzt, da diese in alkalischwäßrig-alkoholischen Lösungsmittelsystemen besonders leicht löslich sind. Auch Mischpolymerisate mit Anhydridgruppen können mit gutem Erfolg verwendet werden.

Ganz besonders geeignet sind Mischpolymerisate aus Styrol und Maleinsäureanhydrid, wie z. B. die unter dem Namen Scripset® der Monsanto, USA, bekannten ; auch Phenolharze, wie z. B. die unter dem Namen Alnovol® der Hoechst AG bekannten, haben sich gut bewährt.

Zur Erweiterung des spektralen Empfindlichkeitsbereiches bis etwa 650 nm ist es bekannt, die verschiedensten Farbstoffe verschiedener Verbindungsklassen als Sensibilisatoren zu verwenden. Als wirksam seien beispielsweise die in den Farbstofftabellen von Schultz (7. Auflage, 1 Band, 1931) aufgeführten Farbstoffe genannt : Triarylmethanfarbstoffe, wie Brillantgrün (Nr. 760, S. 314, C. I. 24040), Victoriablau B (Nr. 822, S. 347), Methylviolett (Nr. 783, S. 327), Kristallviolett (Nr. 785, S. 329), Säureviolett 6B (Nr. 831, S. 351) ; Xanthenfarbstoffe, und zwar Rhodamine, wie Rhodamin B (Nr. 864, S. 365), Rhodamin 6G (Nr. 866, S. 366), Rhodamin G extra (Nr. 865, S. 366), Sulforhodamin B (Nr. 863, S. 364) und Echtsäureeosin G (Nr. 870, S. 368) sowie Phthaleine, wie Eosin S (Nr. 883, S. 375), Eosin A (Nr. 881, S. 374), Erythrosin (Nr. 886, S. 376), Phloxin (Nr. 890, S. 378), Rose bengale (Nr. 889, S. 378) und Fluorescein (Nr. 880, S. 373) ; Thiazinfarbstoffe, wie Methylenblau (Nr. 1038, S. 449) ; Acridinfarbstoffe, wie Acridingelb (Nr. 901, S. 383), Acridinorange (Nr. 908, S. 387) und Trypaflavin (Nr. 906, S. 386) ; Chinolinfarbstoffe, wie Pinacyanol (Nr. 924, S. 396) und Kryptocyanin (Nr. 927, S. 397) ; Chinonfarbstoffe und Ketonfarbstoffe, wie Alizarin (Nr. 1141, S. 449), Alizarinrot S (Nr. 1145, S. 502) und Chinizarin (Nr. 1148, S. 504).

Auch Cyaninfarbstoffe, wie Astrazongelb 3G (C. I. 48 055), Astrazongelb 5G (C. I. 48 065) oder Basic Yellow 52 115 (C. I. 48 060) ; ferner Astrazonorange 3R (C. I. Basic Orange 27), Astrazongelb 7GLL (C. I. Basic Yellow 21), Astrazongelb GRL (C. I. Basic Yellow 29) und Astragelb® (C. I. Basic Yellow 44) werden eingesetzt. Als ganz besonders geeignet erweisen sich Astrazonorange R (C. I. 48 040) und Astrazonorange G (C. I. 48 035). Die Farbstoffe werden insbesondere im Gewichtsverhältnis 0,001 bis 0,1 Gewichtsteile pro Gewichtsteil Photoleiter verwendet. Die photoleitfähige Schicht ist vorzugsweise 2 bis 10 µm dick.

Als Schichtträger für die photoleitfähigen Schichten werden beispielsweise Folien aus Metallen, wie Aluminium, Zink, Kupfer, Celluloseprodukten, wie Papier, Cellulosehydrat, Celluloseestern, wie Celluloseacetat, Cellulosebutyrat, oder Kunststoffen, wie Polyolefinen, z. B. Polyethylen, Polypropylen, Polyvinylverbindungen, wie Polyvinylchlorid, Polyvinylidenchlorid, Polystyrol, Polyacrylverbindungen, wie Polyacrylnitril, Polymethacrylat, Polyester, wie Polyterephthalsäureester, Polyamide und Polyurethane, genannt.

Verwendet man Papier als Schichtträger, so empfiehlt es sich, dieses gegen das Eindringen der Beschichtungsflüssigkeiten vorzubehandeln. Auch mit Metall, z. B. Aluminium kaschierte oder bedampfte Folien eignen sich gut als Schichtträger.

Als Schichtträger für die elektrophotographische Herstellung von Druckformen und gedruckten Schaltungen können insbesondere die bekannten Materialien eingesetzt werden, wie z. B. Aluminium-, Zink-, Magnesium, Kupferplatten oder Mehrmetallplatten.

Besonders bewährt haben sich oberflächenveredelte Aluminiumfolien. Die Oberflächenveredelung besteht in einer mechanischen oder elektrochemischen Aufrauhung und gegebenenfalls in einer anschließenden Anodisierung und Behandlung mit Polyvinylphosphonsäure gemäß DE-OS 1 621 478 (entsprechend GB-PS 1 230 447). Hierdurch wird eine höhere Druckauflage und eine geringere Anfälligkeit gegen Oxidation erzielt.

Die Erfindung wird anhand der folgenden Beispiele näher erläutert.

Herstellung eines erfindungsgemäßen Kondensationsproduktes :

In einem 2-Liter-Dreihalskolben legt man 750 g Essigsäureanhydrid vor und trägt unter Rühren 260 g Benzophenon-2-carbonsäure ein. Durch Erwärmen auf 50 °C erhält man eine klare Lösung. In diese Lösung gibt man unter Rühren rasch 164 g Diethylanilin zu, erhitzt zum Sieden und läßt 5 Std. unter Rückfluß sieden (136 bis 140 °C). Nach etwa einstündigem Nachrühren hat sich das Reaktionsgemisch auf etwa 60 °C abgekühlt. Jetzt tropft man das Reaktionsgemisch innerhalb ca. 30 Minuten unter Rühren in ein offenes Gefäß mit 5000 g Eis/Wasser. Das Produkt fällt in kleinen Kügelchen aus, welche man absaugt und anschließend mit Wasser gut auswäscht und evtl. zerreibt. Trocknung bei ca. 70 °C. Ausbeute : 342 g Rohprodukt. Schmelzpunkt : 112 bis 118 °C.

Reinigung des Rohproduktes :

Nach Umkristallisation des Rohproduktes in der 6-fachen Menge Ethanol und Filtration erhält man ein Produkt mit folgenden Spezifikationen : Ausbeute : 298 g (= 83,5 % der Theorie), Schmelzpunkt : 120 bis 121 °C, Sinnenprobe : farbloses Pulver, Analyse : berechnet : 3,9 % N, gefunden : 4,0 % N.

Beispiel 1

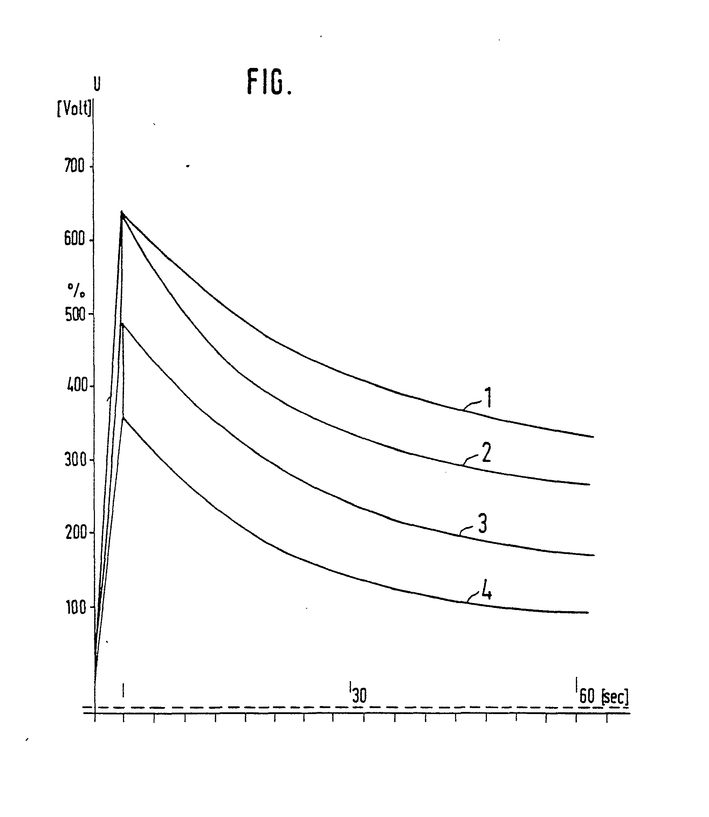

Eine Lösung von 18 g 2,5-Bis(4'-diethylaminopheny)-1,3,4-oxdiazol und 27 g eines Mischpolymerisats aus Styrol und Maleinsäureanhydrid in 130 g Glykolmonomethylether, 170 g Tetrahydrofuran und 50 g Butylacetat, der man 20 g einer methanolischen Lösung von 0,9 g Astrazonorange R (C. I. 48040) und 0,09 g Rhodamin FB (C. I. 45170) zugesetzt hat, wird maschinell auf eine elektrochemisch aufgerauhte, anodisierte Aluminiumfolie aufgebracht. Nach dem Trocknen der Schicht im Dunkeln lädt man sie, wie in der beigefügten Figur graphisch dargestellt, mit einer Corona auf — 650 V auf. Mißt man die Aufladung nach einer Minute Verweilzeit im Dunkeln, so stellt man fest, daß sie auf — 285 V, d. h. auf 44 % der ursprünglichen Aufladung, entladen ist (Kurve 2). Belichtet man die Schicht vor der Aufladung, indem man sie 1 Minute einer Raumbeleuchtung von 440 Lux aussetzt, und lädt sie dann unter gleichen Coronabedingungen wie oben auf, so stellt man fest, daß nur eine Aufladung von — 370 V erreicht wird, was 56 % der nicht vorbelichteten Schicht entspricht. Bewahrt man die so aufgeladene Schicht eine Minute im Dunkeln auf, so mißt man nur noch — 105 V, was 28 % der ursprünglichen Aufladung entspricht (Kurve 4). Ersetzt man nun ein Viertel der in die Beschichtungslösung eingesetzten Menge 2,5-Bis-(4'-diethylaminophenyl)-1,3,4-oxdiazol durch 4,5 g eines Reaktionsproduktes aus 4'-Methylbenzophenon-2-carbonsäure und Diethylanilin, so kann man nach dem Verdunsten des Lösungsmittels und dem Aufladen der Schicht mit Hilfe einer Corona auf — 650 V feststellen, daß die Aufladung nach einer Minute nur auf — 350 V, gleich 53 % der Ausgangsaufladung, abgesunken ist (Kurve 1). Belichtet man die Schicht vor der Aufladung, wie oben beschrieben, 1 Minute bei Raumbeleuchtung mit 440 Lux und lädt sie dann unter gleichen Bedingungen auf, so erreicht man eine Aufladung von — 500 V, gleich 75 % der nicht vorbelichteten Schicht. Nach einer Minute mißt man auf der vorbelichteten und aufgeladenen Schicht — 185 V, gleich 37 % der ursprünglichen Aufladung (Kurve 3).

In der Hellentladung unterscheiden sich beide Schichten nur geringfügig, so daß beide Schichten in einer Reprokamera bei gleichen Belichtungszeiten bebildert werden und zu einer Flachdruckform verarbeitet werden können. Dazu wird die photoleitfähige Schicht mit Hilfe einer Corona auf — 450 V aufgeladen und in einer Reprokamera 24 Sekunden mit vier 1000 W Halogenlampen bildmäßig belichtet. Das auf der Schicht entstandene latente Ladungsbild wird mit Hilfe einer Magnetwalze und eines handelsüblichen elektrophotographischen Entwicklers entwickelt. Das entwickelte Bild wird durch zweiminütiges Erwärmen auf 180 °C fixiert. Die Umwandlung in eine Druckform erfolgt dadurch, daß man die beschichtete Aluminiumfolie mit dem fixierten Tonerbild in eine Lösung von 35 g Natriummetasilikat · 9 $H_2O$ in 140 ml Glycerin mit einem Wassergehalt von 20 %, 550 ml Ethylenglykol und 140 ml Ethanol taucht. Nach einer Minute spült man die in den nicht betonerten Stellen angelöste Photoleiterschicht unter leichtem Reiben mit einem Wasserstrahl ab. Vergleicht man die auf diese Weise erzeugte Druckform mit einer analog hergestellten, die den Zusatz des erfindungsgemäßen Kondensationsproduktes aus 4'-Methylbenzophenon-2-carbonsäure und Diethylanilin in der Schicht nicht enthält, so stellt man fest, daß die Auflösung und der Tonwertumfang gerasterter Bildteile bei der erfindungsgemäßen Schicht wesentlich besser ist.

Beispiel 2

Auf eine durch Drahtbürstung mechanisch oberflächlich aufgerauhte Aluminiumfolie trägt man eine Lösung von 22,5 g 2,5-Bis(4'-diethylaminophenyl)-1,3,4,oxdiazol, 22,5 g eines Mischpolymerisats aus Styrol und Maleinsäureanhydrid, 1,125 g Astrazonorange R (C. I. 48040) und 0,225 g Brillantgrün (C. I. 42040) in 130 g Glykolmonomethylether, 170 g Tetrahydrofuran und 50 g Butylacetat so auf, daß nach dem Verdunsten der Lösungsmittel eine Schicht von 5 μm Dicke zurückbleibt. Diese Schicht wird im Dunkeln mit Hilfe einer Corona auf — 650 V aufgeladen. Nach einer Minute Verweilzeit im Dunkeln mißt man eine Aufladung von — 295 V, was 46 % der ursprünglichen Aufladung entspricht. Belichtet man zuvor die Schicht 1 Minute bei Raumbeleuchtung von 440 Lux und lädt dann unter den gleichen Bedingungen auf wie die nicht vorbelichtete Schicht, so erzielt man eine Aufladung von — 570 V, entsprechend 89 % der Dunkelaufladung. Nach einer Minute im Dunkeln reduziert sich die Aufladung auf — 205 V, entsprechend 36 % der vorbelichteten, aufgeladenen Schicht.

Ersetzt man 2/5 des Oxdiazols durch 9 g eines Kondensationsproduktes aus Benzophenon-2-carbonsäure und Diethylanilin und lädt die Schicht auf — 650 V auf, so mißt man nach einer Minute im Dunkeln — 405 V, was 61 % der Ausgangsaufladung entspricht. Nach einer Vorbelichtung unter den oben beschriebenen Bedingungen lädt sich die Schicht auf — 575 V, entsprechend 91 % der nicht vorbelichteten Schicht, auf. Diese vorbelichtete aufgeladene Schicht weist nach einer Minute eine Aufladung von — 300 V, entsprechend 52 % der ursprünglichen Aufladung, auf.

Durch die teilweise Substitution des Oxdiazols in der Schicht (von 50 % auf 30 % Anteil) wird die Hellentladung der Schicht etwas beeinträchtigt. Bei der Verarbeitung der durch das Kondensationsprodukt teilweise substituierten Schicht in der Reprokamera muß daher die Belichtungszeit um 20 % erhöht werden, was einer praktischen Anwendung aber nicht entgegensteht. Dafür ist der Kontrast des entwickelten Bildes aufgrund der geringeren Dunkelentladung erheblich verbessert.

## Patentansprüche

1. Elektrophotographisches Aufzeichnungsmaterial, bestehend aus einem elektrisch leitenden, insbesondere zur Herstellung von Druckformen oder gedruckten Schaltungen geeigneten Schichtträger und einer photoleitfähigen Schicht aus organischem Photoleiter, Bindemittel und Sensibilisator, dadurch gekennzeichnet, daß die photoleitfähige Schicht zusätzlich ein Kondensationsprodukt aus Benzophenon-2-carbonsäure und einem Dialkylanilin enthält.

2. Aufzeichnungsmaterial nach Anspruch 1, dadurch gekennzeichnet, daß die photoleitfähige Schicht ein Kondensationsprodukt aus Benzophenon-2-carbonsäure und Diethylanilin enthält.

3. Aufzeichnungsmaterial nach Anspruch 1, dadurch gekennzeichnet, daß die photoleitfähige Schicht ein Kondensationsprodukt aus 4'-Methylbenzophenon-2-carbonsäure und Diethylanilin enthält.

4. Aufzeichnungsmaterial nach Ansprüchen 1 bis 3, dadurch gekennzeichnet, daß das Kondensationsprodukt im Gemisch mit 2,5-Bis-(4'-dialkylaminophenyl)-oxdiazol-1,3,4 vorhanden ist.

5. Aufzeichnungsmaterial nach Ansprüchen 1 bis 4, dadurch gekennzeichnet, daß das Mischungsverhältnis von organischem Photoleiter und Kondensationsprodukt im Bereich von 1 :1 bis 5 :1 Gewichtsteilen vorliegt.

6. Aufzeichnungsmaterial nach Ansprüchen 1 bis 5, dadurch gekennzeichnet, daß als Sensibilisator ein Gemisch aus Astrazonorange® (C. I. 48040) und Rhodaminfarbstoff vorhanden ist.

7. Aufzeichnungsmaterial nach Ansprüchen 1 bis 5, dadurch gekennzeichnet, daß als Sensibilisator ein Gemisch aus Astrazonorange® (C. I. 48040) und Brillantgrün (C. I. 42040) vorhanden ist.

8. Aufzeichnungsmaterial nach Ansprüchen 1 bis 7, dadurch gekennzeichnet, daß die photoleitfähige Schicht 2 bis 10 µm dick ist.

9. Aufzeichnungsmaterial nach Ansprüchen 1 bis 8, dadurch gekennzeichnet, daß die photoleitfähige Schicht ein alkalisch lösliches Bindemittel enthält.

10. Aufzeichnungsmaterial nach Anspruch 9, dadurch gekennzeichnet, daß als Bindemittel ein Mischpolymerisat aus Styrol und Maleinsäureanhydrid oder Phenolharz vorhanden ist.

## Claims

1. Electrophotographic recording material composed of an electrically conductive layer support, which is in particular suitable for the production of printing forms or printed circuits, and of a photoconductive layer comprised of an organic photoconductor, a binder and a sensitizer, wherein the photoconductive layer additionally contains a condensation product of benzophenone-2-carboxylic acid and a dialkyl aniline.

2. Recording material as in Claim 1, wherein the photoconductive layer contains a condensation product of benzophenone-2-carboxylic acid and diethyl aniline.

3. Recording material as in Claim 1, wherein the photoconductive layer contains a condensation product of 4'-methylbenzophenone-2-carboxylic acid and diethyl aniline.

4. Recording material as in Claims 1 to 3, wherein the condensation product is contained in a mixture with 2,5-bis(4'-dialkylaminophenyl)-oxadiazole-1,3,4.

5. Recording material as in Claims 1 to 4, wherein the mixing ratio of organic photoconductor to condensation product varies within a range of 1 :1 to 5 :1 parts by weight.

6. Recording material as claimed in Claims 1 to 5, wherein the sensitizer is a mixture of Astrazone Orange ® (C. I. 48 040) and a Rhodamine dyestuff.

7. Recording material as in Claims 1 to 5 wherein the sensitizer is a mixture of Astrazone Orange ® (C. I. 48 040) and Brillant Green (C. I. 42 040).

8. Recording material as in Claims 1 to 7, wherein the photoconductive layer is 2 to 10 µm thick.

9. Recording material as in Claims 1 to 8, wherein the photoconductive layer contains an alkali-soluble binder.

10. Recording material as in Claim 9, wherein the binder employed is a copolymer of styrene and maleic acid anhydride or phenol resin.

## Revendications

1. Matériau de reproduction électrophotographique, constitué d'un support électroconducteur, particulièrement approprié pour la production de formes d'imprimerie et de circuits imprimés et d'une couche photoconductrice composée d'un photoconducteur, d'un liant et d'un sensibilisateur, caractérisé en ce que la couche photoconductrice contient en outre un produit de condensation d'acide benzophénone-2-carboxylique et d'une dialkylaniline.

2. Matériau de reproduction selon la revendication 1, caractérisé en ce que la couche photoconductrice contient un produit de condensation d'acide benzophénone-2-carboxylique et de diéthylaniline.

3. Matériau de reproduction selon la revendication 1, caractérisé en ce que la couche photoconductrice contient un produit de condensation d'acide 4'-méthylbenzophénone-2-carboxylique et de diéthylaniline.

4. Matériau de reproduction selon les revendications 1 à 3, caractérisé en ce que le produit de condensation est présent en mélange avec le 2,5-bis-(4'-dialkylaminophényl)-1,3,5-oxadiazole.

5. Matériau de reproduction selon l'une quelconque des revendications 1 à 4, caractérisé en ce que le rapport de mélange du photoconducteur organique et du produit de condensation est de l'ordre de 1 :1 à 5 :1 parties en poids.

6. Matériau de reproduction selon l'une quelconque des revendications 1 à 5, caractérisé en ce que, comme sensibilisateur, on utilise un mélange d'Orange d'Astrazone® (C. I. 48040) et de colorant de Rhodamine.

7. Matériau de reproduction selon l'une quelconque des revendications 1 à 5, caractérisé en ce que, comme sensibilisateur, on utilise un mélange d'Orange d'Astrazone® (C. I.48040) et de Vert Brillant (C. I. 42040).

8. Matériau de reproduction selon l'une quelconque des revendications 1 à 7, caractérisé en ce que la couche photoconductrice a une épaisseur de 2 à 10 µm.

9. Matériau de reproduction selon l'une quelconque des revendications 1 à 8, caractérisé en ce que la couche photoconductrice contient un liant soluble dans les alcalis.

10. Matériau de reproduction selon la revendication 9, caractérisé en ce que, comme liant, on utilise un copolymère de styrène et d'anhydride maléique ou une résine phénolique.

FIG.